# EUROPÄISCHE PATENTSCHRIFT

(11) **EP 0 433 742 B1**
(45) Veröffentlichungstag und Bekanntmachung des Hinweises auf die Patenterteilung: **02.08.1995**
(21) Anmeldenummer: 90123080.5
(22) Anmeldetag: 03.12.1990
(51) Int. Cl.: H01L 31/0203, H01L 25/16, H05K 1/18

(54) **Fotomodul**
Photo module
Module photosensible

(30) Priorität: 18.12.1989 DE 3941679
(43) Veröffentlichungstag der Anmeldung: 26.06.1991
(73) Patentinhaber: TEMIC TELEFUNKEN microelectronic GmbH, 74072 Heilbronn (DE)
(72) Erfinder: Schöberl, Werner, W-7101 Massenbachhausen (DE)
(74) Vertreter: Maute, Hans-Jürgen, Dipl.-Ing.

(56) Entgegenhaltungen:
- DE-U- 8 911 283
- FR-A- 2 503 458
- US-A- 4 758 767
- PATENT ABSTRACTS OF JAPAN , vol. 8, no. 49 (E-230)6. März 1984 & JP-A-58 204 573 (SUMITOMO DENKI KOGYO K.K.) 29. November 1983
- PATENT ABSTRACTS OF JAPAN ,vol. 11, no. 400 (E-569)(2847) 26. Dezember 1987 & JP-A-62 160 773 ( SONY CORP. ) 16. Juli 1987
- PATENT ABSTRACTS OF JAPAN, vol. 8, no. 53 (E-231)(1490) 9. März 1984 & JP-A-58 206 177 ( SUMITOMO DENKI KOGYO K.K. ) 1. Dezember 1983

## Beschreibung

Die Erfindung betrifft ein Fotomodul nach dem Oberbegriff des Patentanspruchs 1.

Ein derartiges Fotomodul ist aus der JP-A-58 204 573 bekannt. Bei dem dort beschriebenen Fotomodul weist eine in ein Kunststoffgehäuse eingebaute Hybrid-Trägerplatte auf der einen Oberflächenseite eine Fotodiode und eine Leuchtdiode und auf der anderen Oberflächenseite passive SMD-(Surface Mounted Devices)-Bauelemente sowie einen integrierten Schaltkreis (IC) in Chipform auf. Weder die aktiven noch die passiven Bauelemente sind dabei von einer Schutzschicht bedeckt. In der JP-A-62 160 773 wird ein Fotomodul beschrieben, bei dem eine Fotodiode und ein IC zusammen auf einer Trägerplatte von einer Harzschicht bedeckt sind. Bei einem weiteren in der JP-A-62 102 548 beschriebenen Fotomodul sind ein Fototransistor und ein IC zusammen in einer transparenten Harzschicht eingebettet. Auf diese transparente Harzschicht ist, außer auf einen als Fenster ausgebildeten Bereich über dem Fototransistor, eine schwarze Harzschicht als Lichtschutz aufgebracht. Diese schwarze Harzschicht bietet jedoch keinen ausreichenden Lichtschutz, da durch die transparente Harzschicht Streulicht zum IC gelangen und dort Störungen hervorrufen kann.

Der Erfindung liegt die Aufgabe zugrunde, ein verbessertes Fotomodul in kleiner Bauform anzugeben, bei dem eine möglichst störungsfreie Signalverarbeitung möglich ist. Die Aufgabe wird erfindungsgemäß durch die Merkmale im Kennzeichen des Patentanspruchs 1 gelöst. Vorteilhafte Ausgestaltungen und Weiterbildungen ergeben sich aus den Unteransprüchen.

Das erfindungsgemäße Fotomodul weist eine Hybrid-Trägerplatte auf, auf deren einer Oberflächenseite mindestens das Fotoempfangselement und ein von schwarzem Epoxyharz bedeckter integrierter Schaltkreis in Chipform angeordnet sind, während auf der gegenüberliegenden Oberflächenseite der Trägerplatte weitere elektrische Bauelemente angeordnet und miteinander verschaltet sind.

Da Fotodiode und IC als Chip-Bauteile ausgebildet sind und, vorzugsweise mittels eines Silber-Epoxy-Klebers, auf die Trägerplatte aufgeklebt werden, können die beiden Bauteile räumlich sehr nah zueinander gebracht werden, so daß auch die Verbindung zwischen ihnen sehr kurz gestaltet werden kann (beispielsweise 1,5 - 2,5 mm Abstand zwischen Fotodiode und IC-Eingang). Dadurch können einerseits ungewollte Rückwirkungen in der Schaltung bzw. Störstrahlungseinflüsse von außen weitgehendst vermieden werden; andererseits kann eine beträchtliche Reduzierung der benötigten Fläche auf der Trägerplatte erreicht werden, was infolge geringeren Materialbedarfs auch Kosteneinsparungen mit sich bringt.

Die Verbindung zwischen den Bauteilen wird mit einer in der Halbleitertechnik üblichen Kontaktierungsmethode durchgeführt; vorzugsweise werden dazu dünne Aluminium-Silizium-Drähte unter Zuhilfenahme von Ultraschalltechnik eingesetzt.

Die Beschaltung auf der Trägerplatte ist so ausgelegt, daß alle kritischen Pfade, die eine Mitkopplung bzw. Rückkopplung in der Schaltung verursachen können, durch entsprechende Masseleitbahnen abgeschirmt werden; diese kritischen Pfade sind die Verbindung zwischen dem Fotodiodenausgang und dem Eingang des ICs, die von den Bauelementen ausgehenden Bondpads sowie die Anschlußleitbahnen zu den externen Anschlußpins, die durch Masseleitungen bzw. Masseflächen abgeschirmt bzw. entkoppelt werden.

Auf der anderen Oberflächenseite der Schaltungsplatine sind als periphere Beschaltung des Fotomoduls weitere aktive und/oder passive SMD-Bauteile angeordnet, die beispielsweise zur Filteranpassung, d. h. zur Selektion eines bestimmten Frequenzbereichs dienen.

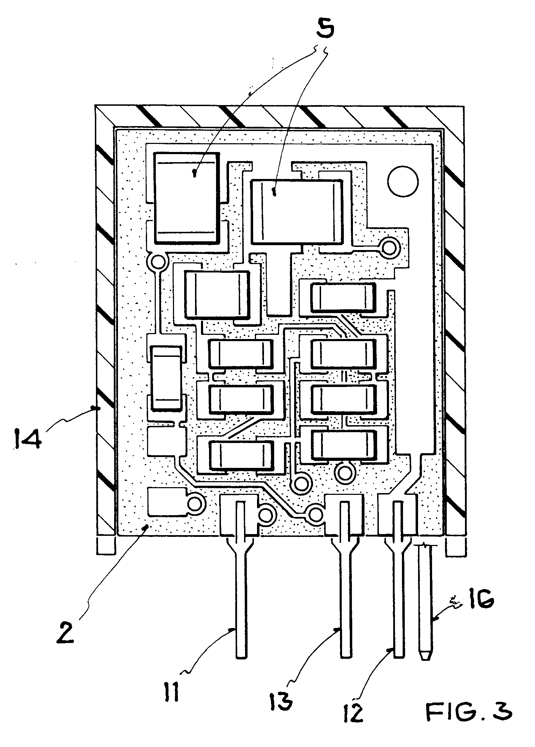

Im folgenden soll die Erfindung anhand eines in den Figuren 1 bis 3 dargestellten Ausführungsbeispiels näher beschrieben werden.
Dabei zeigen:
- Fig. 1: einen Querschnitt durch das Fotomodul mit Vorder- und Rückseite der Trägerplatte,
- Fig. 2: in Draufsicht die Vorderseite der Trägerplatte und
- Fig. 3: in Draufsicht die Rückseite der Trägerplatte.

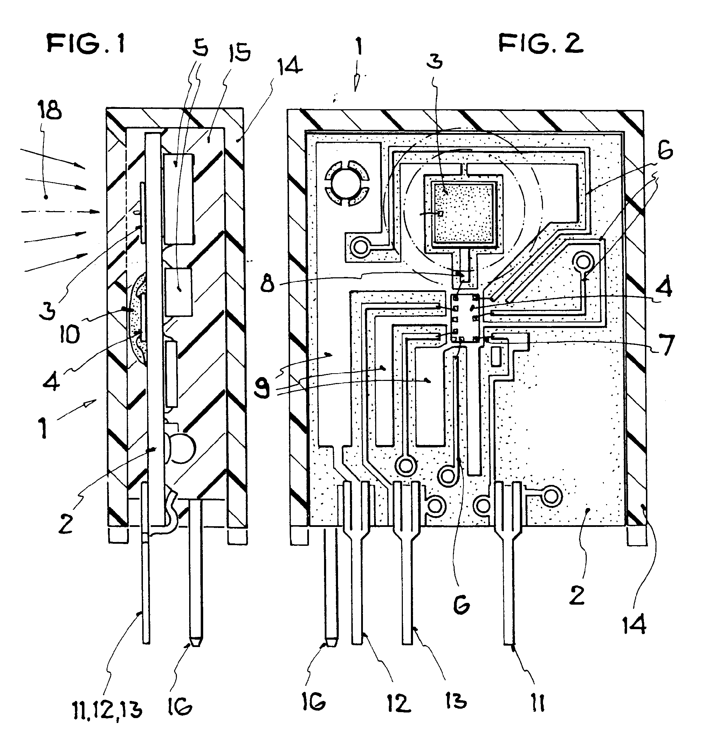

Die vorgegebene Schaltungsanordnung mit Anschlußleitbahnen 6, Kontaktflecken, Durchkontaktierungen etc., wird auf eine Leiterplatte 2, vorzugsweise Glasfaserepoxidlaminat, durch fotolithographischen Prozeß aufgebracht. Damit die aktiven Halbleiterchips 3, 4 direkt kontaktiert werden können, wird auf die Kupfer-Leitbahnen eine 1 bis 2 »m dicke Nickelschicht galvanisch aufgewachsen und zum Oberflächenschutz mit einer hauchdünnen Goldschicht (Dicke 0,05 - 0,3 »m) versehen. Anschließend wird, wie in der SMD-Technologie üblich, Lotpaste (Zinn oder Blei) mittels Siebdrucktechnik auf die Rückseite der Trägerplatte aufgebracht und die passiven Bauteile 5 der Schaltung - Widerstände und Kondensatoren - mit Hilfe eines Montageautomaten aufgebracht und in einem Reflowofen gelötet. Dadurch werden Montagefehler vermieden und eine hohe Zuverlässigkeit in der Beschaltung erreicht.
Die aktiven Bauteile (Fotodiode 3 und IC 4) werden nun als Chip-Bauteile mittels eines Silber-Epoxy-Klebers auf die Vorderseite der Trägerplatte aufgeklebt und durch Aluminiumdrähte 7 (Durchmesser beispielsweise 25 »m) mit ca. 1 % Siliziumdotierung kontaktiert, wobei die Herstellung der Kontakte bei Raumtemperatur mit Ultraschallunterstützung vorgenommen wird.
Der IC-Chip 4 wird zum Schutz gegen Fremdlicht und zur mechanischen Stabilisierung mit einem lichtundurchlässigen, schwarzen Epoxytropfen 10 (Fig. 1) abgedeckt.
Die Fotodiodenverbindung wird mit einem lichtdurchlässigen Medium (vorzugsweise Silikon) geschützt.
Die Anschlußelektroden 11, 12, 13 werden mit Anschlußflächen auf der Leiterplatte 2 durch Einpressen, Klemmen oder Löten verbunden. Beim Fotomodul nach der Erfindung sind nur drei Anschlußelektroden notwendig, wodurch auch die erforderliche periphere Beschaltung reduziert wird. Vorzugsweise sind diese Anschlußelektroden die Stromversorgung 11, die Masseverbindung der Schaltung 12 und der Signalausgang 13 und verlaufen entweder parallel oder senkrecht zur Tragerplatte 2. Anschließend wird die Schaltungsplatine in ein aus einem Kunststoffkörper bestehendes Gehäuse 14 eingebracht und mittels der Vergußmasse 15 vergossen. Das Gehäuse 14 wird mit einem separaten Anschlußpin 16 kontaktiert.

Der integrierte Schaltkreis 4 enthält als wesentliche Schaltungskomponenten einen Vorverstärker, eine Logikschaltung und eine Spannungsstabilisierungsschaltung. Die passiven Bauelemente 5 dienen zur Ausfilterung eines bestimmten Frequenzbereichs.
Das Fotomodul ist beispielsweise in der Lage IR-Fernsteuerlichtimpulse 18 mit einer Frequenz größer als 20 kHz auszuwerten. Der Frequenzbereich wird jedoch sowohl von den aktiven als auch von den passiven Bauteilen bestimmt und kann durch Veränderung der nötigen Komponenten beträchtlich ausgeweitet werden. Die Bandbreite des Fotomoduls beträgt beispielsweise 3 bis 6 kHz.

## Patentansprüche

1. Fotomodul (1), das auf einer Oberflächenseite einer Hybrid-Trägerplatte (2) mindestens das als Fotodiode (3) ausgebildete Fotoempfangselement sowie einen integrierten Schaltkreis (4) in Chipform und auf der gegenüberliegenden Oberflächenseite der Trägerplatte (2) miteinander verschaltete aktive und passive SMD (Surface Mounted Devices)-Bauelemente (5) aufweist, dadurch gekennzeichnet, daß die Trägerplatte (2) aus Glasfaserepoxid besteht, auf der Anschlußleitbahnen (6) aufgebracht sind, daß die Verbindungsleitbahn (8) zwischen Fotodiode (3) und integriertem Schaltkreis (4), die Kontakte der Bauelemente sowie die Anschlußleitbahnen (6) durch Masseleitungen (9) bzw. Masseflächen abgeschirmt sind, daß der integrierte Schaltkreis (4) mit einem lichtundurchlässigen, schwarzen Epoxyharz (10) bedeckt ist, und daß die Trägerplatte (2) vollständig in einen Kunststoffkörper (14) eingebettet ist.

2. Fotomodul nach Anspruch 1, dadurch gekennzeichnet, daß die Fotodiode (3) und der integrierte Schaltkreis (4) unmittelbar nebeneinander angeordnet sind.

3. Fotomodul nach einem der vorherigen Ansprüche, dadurch gekennzeichnet, daß die Trägerplatte (2) nur drei externe Anschlußelektroden (11, 12, 13) besitzt.

4. Fotomodul nach Anspruch 3, dadurch gekennzeichnet, daß die drei externen Anschlußelektroden (11, 12, 13) der Trägerplatte (2) die Stromversorgung (11), die Masseverbindung (12) und der Signalausgang (13) sind.

5. Fotomodul nach Ansprüche 3 oder 4, dadurch gekennzeichnet, daß die externen Anschlußelektroden (11, 12, 13) mit Anschlußflächen auf der Trägerplatte (2) verbunden sind, und daß die Anschlußelektroden (11, 12, 13) entweder parallel oder senkrecht zur Trägerplatte (2) verlaufen.

6. Verfahren zur Herstellung eines Fotomoduls nach einem der vorherigen Ansprüche, dadurch gekennzeichnet, daß die Fotodiode (3) und der integrierte Schaltkreis (4) in Chipform mittels eines Silber-Epoxy-Klebers auf die eine Oberflächenseite der Trägerplatte (2) aufgeklebt werden.

7. Verfahren nach Anspruch 6, dadurch gekennzeichnet, daß die aktiven Bauelemente (3, 4) mittels Al-Si-Drähten (7) und mit Ultraschallunterstützung kontaktiert werden.

8. Verfahren nach Anspruch 6 oder 7, dadurch gekennzeichnet, daß auf die Trägerplatte (2) Anschlußleitbahnen (6) aus Kupfer aufgebracht werden, die anschließend vernickelt und mit einer dünnen Goldschicht überzogen werden.

## Claims

1. A photo-module (1) which on one surface side of a hybrid carrier plate (2) comprises at least the photo-receiving element in the form of a photo-diode (3) and an integrated circuit (4) in chip form and on the opposite surface side of the carrier plate (2) comprises interconnected active and passive SMD (surface mounted device) components (5), characterised in that the carrier plate (2) consists of glass fibre epoxide on which connecting conductor paths (6) are applied, that the connecting conductor path (8) between the photo-diode (3) and the integrated circuit (4), the contacts of the components and the connecting conductor paths (6) are screened by earthing wires (9) or earthing surfaces, that the integrated circuit (4) is covered with an opaque, black epoxy resin (10), and that the carrier plate (2) is completely embedded in a synthetic resin body (14).

2. A photo-module as claimed in Claim 1, characterised in that the photo-diode (3) and the integrated circuit (4) are arranged directly next to one another.

3. A photo-module as claimed in one of the preceding claims, characterised in that the carrier plate (2) possesses only three external terminal electrodes (11, 12, 13).

4. A photo-module as claimed in Claim 3, characterised in that the three external terminal electrodes (11, 12, 13) of the carrier plate (12) are the current supply (11), the earth connection (12) and the signal output (13).

5. A photo-module as claimed in Claims 3 or 4, characterised in that the external terminal electrodes (11, 12, 13) are connected to terminal surfaces on the carrier plate (2), and that the terminal electrodes (11, 12, 13) extend either in parallel or at right angles to the carrier plate (2).

6. A process for the production of a photo-module as claimed in one of the preceding claims, characterised in that the photo-diode (3) and the integrated circuit (4) in chip form are glued by means of a silver-epoxy adhesive to the one surface side of the carrier plate (2).

7. A process as claimed in Claim 6, characterised in that the active components (3, 4) are contacted by means of Al-Si wires (7) and with ultrasonic support.

8. A process as claimed in Claim 6 or 7, characterised in that connecting conductor paths (6) consisting of copper are applied to the carrier plate (2), which connecting conductor paths (6) are subsequently nickel-plated and coated with a thin gold layer.

## Revendications

1. Module photosensible (1) comprenant, sur une face d'une plaque support hybride (2), au moins l'élément photorécepteur, constitué par une photodiode (3), ainsi qu'un circuit intégré (4), sous la forme de puces, de même que, sur la face opposée de la plaque support (2), des composants (5) actifs et passifs du type des composants pour montage en surface (CMS) qui sont interconnectés, caractérisé en ce que la plaque support (2) est en résine époxy-fibre de verre, sur laquelle sont appliquées des pistes conductives de raccordement (6), que la piste conductive de liaison (8) entre la photodiode (3) et le circuit intégré (4), les contacts des composants ainsi que les pistes conductives de raccordement (6), sont blindés par des conducteurs de masse (9) ou des surfaces mises à la masse, que le circuit intégré (4) est recouvert d'une résine époxy noire opaque (10) et que la plaque support (2) est entièremement encapsulée dans une pièce (14) en matière plastique.

2. Module photosensible selon la revendication 1, caractérisé en ce que la photodiode (3) et le circuit intégré (4) sont placés directement l'un à côté de l'autre.

3. Module photosensible selon une des revendications précédentes, caractérisé en ce que la plaque support (2) possède seulement trois électrodes de raccordement externes (11, 12, 13).

4. Module photosensible selon la revendication 3, caractérisé en ce que les trois électrodes de raccordement externes (11, 12, 13) de la plaque support (2) sont l'alimentation (11), la connexion à la masse (12) et la sortie de signal (13).

5. Module photosensible selon la revendication 3 ou 4, caractérisé en ce que les électrodes de raccordement externes (11, 12, 13) sont reliées à des surfaces de raccordement sur la plaque support (2) et que les électrodes de raccordement (11, 12, 13) s'étendent ou bien parallèlement ou alors perpendiculairement à la plaque support (2).

6. Procédé pour fabriquer un module photosensible selon une des revendications précédentes, caractérisé en ce que la photodiode (3) et le circuit intégré (4), sous la forme de puces, sont collés sur une face de la plaque support (2) au moyen d'une colle époxy à l'argent.

7. Procédé selon la revendication 6, caractérisé en ce que le contact avec les composants actifs (3, 4) est établi au moyen de fils Al-Si (7) et avec le soutien d'ultrasons.

8. Procédé selon la revendication 6 ou 7, caractérisé en ce que des pistes conductives de raccordement (6) en cuivre sont appliquées sur la plaque support (2), pistes qui sont ensuite nickelées et recouvertes d'une mince couche d'or.
